# EUROPEAN PATENT APPLICATION

(11) **EP 1 126 594 A2**
(43) Date of publication of application: **22.08.2001**
(21) Application number: 01102631.7
(22) Date of filing: 07.02.2001
(51) Int. Cl.: H03F 1/30

(54) **Compensation for electrical circuitry**

(30) Priority: 17.02.2000 US 511670
(71) Applicant: THE BOEING COMPANY, Seattle, Washington 98124-2207 (US)
(72) Inventor: Chan, Clinton, Chino Hills, CA 91709 (US); Knudsen, Arnold C., Pacific Palisades, CA 90272 (US); Hutton, Frank P., Manhatten Beach, CA 90266 (US); Guenther, Christian H., Los Angeles, CA 90066 (US); Sorace, Ronald E., Torrance, CA 90503 (US); Reinhardt, Victor S., Rancho Palos Verdes, CA 90275 (US)
(74) Representative: Lindner, Michael, Dipl.-Ing.

(57) **Abstract**

A compensation circuit (16) is coupled to an electrical device (20) for compensating the operation of the electrical device (20) in response to a sensed condition. The compensation circuit (16) is coupled to a memory (21) that stores compensation tables. An analog-to-digital circuit is used for converting said analog signal to a digital signal. A compensation portion (30) coupled to the digital-to-analog (46) circuit retrieves a setting value in response to said digital signal. An output section (28) generates a voltage output and a current output that are coupled to the electrical device (20) (Fig. 2).

## Description

### Technical Field

The present invention relates generally to control circuits for electrical circuitry and more particularly to circuits that compensate for such factors as temperature, age or other environmental conditions.

### Background

In the design of electrical circuitry, it is usually desirable to maintain a predetermined performance over the life of the circuit. Circuitry to compensate outputs so that proper signals are generated is desirable. Such circuits have universal utility but are particularly useful in automotive and space applications.

One parameter that is desirable for compensation in space applications is temperature. Known temperature compensation circuits use thermistors and attenuators as sensors and control devices, respectively. However, the processing circuitry used to translate a thermistor input into an attenuator setting can be complex. The components may be bulky and require valuable space and increase in weight.

In space applications, small and lightweight circuitry is very desirable. Also, flexibility and ease of use are design considerations. Previous circuits for compensation involve either a large complement of digital hardware in conjunction with analog-to-digital and digital-to-analog converters or a large collection of analog circuitry. Analog circuitry for applications such as compensation are not only large and cumbersome but also difficult to tune and calibrate.

It would therefore be desirable to provide a compensation circuit that is small, lightweight and easy to calibrate.

### Summary Of The Invention

The present invention is a compensation circuit that is relatively small, lightweight, and easy to control. Because of these features the present invention is particularly suitable for satellite applications.

In one aspect of the invention, a circuit is coupled to an electrical device for compensating the operation of the device in response to a sensed condition. The compensation circuit includes a memory that stores compensation tables. A digital-to-analog converter coupled to a successive approximation register performs an analog-to-digital converter function for converting said sensed condition to a digital signal. A compensation portion coupled to said analog-to-digital function retrieves a setting value from memory in response to said digital signal. The digital-to-analog converter converts said setting value to an analog signal, and an output section generates a voltage output or a current output that is coupled to the electrical device.

In a further aspect of the invention, a method of compensating the operation of an electrical device comprises the steps of: receiving an analog signal from a sensor; converting the analog signal to a digital signal; retrieving a setting value from a memory in response to said digital signal; and driving an output signal coupled to said electrical device in response to said setting value.

One advantage of the invention is that it incorporates a high level of integration so that the circuitry is extremely small and may support more than 20 voltage or current outputs. Also, the present invention is easy to program and to use. A further advantage of the invention is that internal drift of the components is compensated during the calibration process.

The present invention is particularly suited for implementation in a spacecraft environment. When used in combination with a traveling wave tube amplifier, the present invention allows a significant advance in the performance of the traveling wave tube. Also, the present invention allows the capability of loading updated compensation tables for aging and deleterious effects in the environment of the operational circuitry.

Other objects and features of the present invention become apparent from the detailed description of the preferred embodiment in conjunction with the attached drawings and appended claims.

### Brief Description of the Drawings

Figure 1 is a system view of a satellite having a compensation circuit according to the present invention.

Figure 2 is a block diagram of a compensation circuit according to the present invention.

### Detailed Description of the Preferred Embodiment

The following is described with respect to a compensation circuit for use in satellites. However, those skilled in the art would recognize that the compensation circuit of the present invention may have applications beyond satellites including the automotive field. Although the present invention is illustrated with respect to a single sensor system having a single voltage output and a single current output, one skilled in the art would recognize that multiple sensors may be employed with multiple current and voltage outputs.

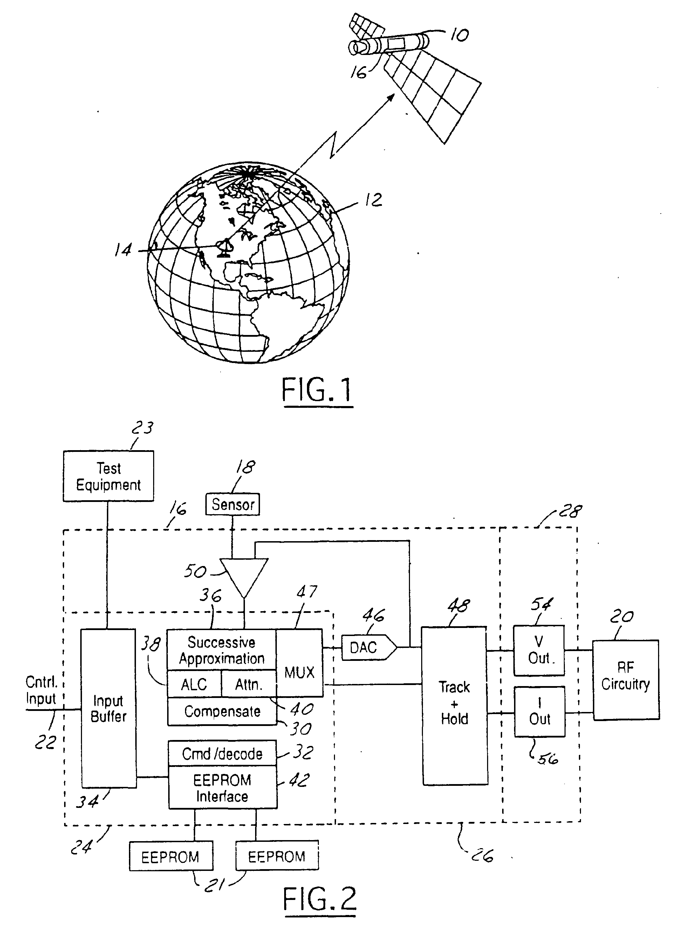

Referring now to Figure 1, a satellite 10 is positioned above the earth 12. Satellite 10 is used for communication with a ground station 14 positioned on earth 12. Satellite 10 and ground station 14 communicate various signals including command and control signals. Satellite 10 includes among its circuitry a compensation circuit 16 that may, for example, compensate RF circuitry or traveling wave tube amplifiers for temperature or other environmental effects.

Referring now to Figure 2, compensation circuit 16 is illustrated in detail. Compensation circuit 16 may be implemented on a single application-specific integrated circuit (ASIC) to minimize the size and weight of the circuit. Of course, one skilled in the art would recognize that compensation circuit 16 may be implemented in several integrated circuits. Compensation circuit 16 is coupled to an analog input such as a sensor 18 that generates an analog signal in response to a sensed condition. In a preferred embodiment, several analog inputs with corresponding circuitry may be employed. Because these inputs would operate in a similar manner, they are not illustrated. Compensation circuit 16 is coupled to an electrical device 20 or electrical circuit that is to be compensated. The electrical device as illustrated is an RF circuit. However, those skilled in the art would recognize various applications of the compensation circuit including space applications such as traveling wave tube amplifiers or non-space applications such as in the automotive field.

Compensation circuit 16 is coupled to a memory device 21 such as an electrically erasable programmable ready only memory (EEPROM). Memory device 21 stores configuration and initialization programming as well as compensation tables based on the analog input from sensor 18. The derivation of the compensation tables is described in the following text.

Compensation circuit 16 has a control input 22 that may be coupled to external control circuitry such as telemetry and control lines. Control input 22 may be used to control various modes of circuit 16.

During the initialization of compensation circuit 16, test equipment 23 may be coupled to compensation circuit 16 to provide testing and programming.

Compensation circuit 16 has a digital portion 24, an analog portion 26, and an output portion 28. The digital portion 24 includes a compensation portion 30, a command/decode circuit 32, and an input buffer 34.

Input buffer 34 is coupled to test equipment 23, control input 20 and command/decode circuit 32. Command/decode circuit 32 is coupled to compensation portion 30. Compensation portion 30 is coupled through analog portion 26 to sensor 18.

A successive approximation register 36, an automatic level control circuit 38, and an attenuator circuit 40 are associated with compensation portion 30.

Command/decode circuit 32 is associated with an EEPROM interface 42 that is coupled to EEPROM 21.

Analog portion 26 has a digital-to-analog converter (DAC) 46 coupled to a multiplexer 47 and to multiple track and hold circuits 48, one for each voltage or current output. Operation with one track and hold circuit is described to simplify the description. Multiplexer 47 couples successive approximation register 36 and attenuator 40 to DAC 46. The attenuator inputs are derived by compensation inputs from the EEPROM 21.

The output of digital-to-analog converter 46 is coupled to a comparator 50 also. Comparator 50 also has an input coupled to sensor 18, and the output of comparator 50 is coupled to the successive approximation register 36. Comparator 50, successive approximation register 36, and digital-to-analog converter 46 act as an analog-to-digital converter for input from the sensor.

Output portion 28 has voltage output 54 and current output 56 that are coupled to a track and hold circuit 48. The voltage output 54 and current output 56 provide signals for compensation of electrical device 20 which may be RF circuitry as illustrated or may include a channel control unit, a driver limiter amplifier, a linearizer unit or other circuitry. Although only one voltage output 54 and one current output 56 are illustrated, multiple outputs may be employed.

The device has at least two modes of operation. The first mode is the initialization mode which includes testing and programming. The second mode is the normal operation mode of the device. During initialization, values derived from test equipment 23 may be stored in memory device 21. During test mode, sensor 18 generates analog signals that are used by digital portion 24 to generate various settings until a desired performance is achieved by the electrical device 20. The automatic level control 38 may be used in this regard to converge to the desired performance. These setting values are stored in EEPROM 21 in program mode. The setting values are essentially a data table that coordinates a condition such as temperature to a value to be converted to an analog form and coupled to electrical device 20 as a current, voltage or both. Also, in test mode the attributes of electrical device 20 are programmed. These attributes include signal routing and final destination information.

Because the actual device is used during initialization, any drift of components may be compensated, also. This allows more components to be acceptable than previously when components exhibiting any drift were discarded typically.

In normal operation, test equipment 23 is not coupled to compensation circuit 16. Sensor 18 generates an analog signal. The analog signal is converted to a digital signal using comparator 50, successive approximation register 36, and digital-to-analog converter 46. The analog signal is compared to the output of digital-to-analog converter 46 at comparator 50. This comparison gives one of two values indicating whether the input from sensor 18 is greater or less than the output of digital-to-analog converter 46. Each bit of the digital word is compared starting from the most significant bit to the least significant bit. The result is placed into successive approximation register 36. The analog input from sensor 18 is converted to a digital word having a number of bits equal to that of the input word. This method for analog-to-digital conversion is generally known in the art.

The successive approximation method allows the temperature sensor to be read digitally into compensation circuit 30. Once the temperature or other reading from sensor 18 is obtained, the setting data from memory 21 may be used either with or without interpolation to set a corresponding voltage, current, or both. Attenuator controls 40 may be set to a desired attenuation level based upon the input signal from sensor 18. The attenuator output is multiplexed to digital-to-analog converter 46 and the corresponding analog outputs are captured by track and hold circuits 48 that drive either voltage output 54 or current output 56.

If the compensation circuit 16 is used for RF circuitry 20, to maintain the quality of the RF signal any noise from digital portion 24 should be reduced by use of commonly known interpolation or moving averages as would be evident to those skilled in the art.

If the compensation circuit 16 is used for temperature compensation and the circuitry is RF electronics, the particular settings for a given temperature may be derived by a complex mathematical function. However, to circumvent the need for complicated analysis, the settings may be derived empirically. In test mode, the unit containing the device may be exercised over various temperatures and the input and output signals 20 may be monitored. At each temperature, the current voltage settings may be derived to maintain the performance of the unit, and these values are recorded in memory 21.

Closed loop output level control and compensation of amplifier devices is performed by automatic level control circuit 38 which may be a first order phase lock loop, for example. The feedback loop of automatic level control circuit 38 includes a response from another analog input. In response to the analog input, a value from memory device 21 may be retrieved and output to the electrical device 20. Automatic level control circuit 38 is used to maintain a desired signal level produced by electrical device 20 at a constant level. Because these functions are implemented in digital circuitry, they are robust against changes in temperature.

Control input 22 may be coupled to external command circuitry such as the telemetry unit of the spacecraft. This control input 22 may be used to update any tables in EEPROM, set the desired attenuation levels of the circuitry, or set the automatic level control circuitry 38.

Error detection and correction for the digital EEPROM memory consists of a modified Hamming Code algorithm giving two bit detection and one bit correction. A preferred embodiment for spacecraft applications employs identically programmed, dual redundant EEPROM's. One EEPROM is active while the other is refreshed periodically. The devices are compared and corrected whenever a one bit error is detected.

One advantage of the invention is that by implementing the compensation circuit 16 in a single ASIC, the area of the circuitry has been reduced from approximately 25 square inches in previous circuits to 0.5 square inches in a constructed embodiment. If the circuitry is implemented in two ASIC's, the area is reduced to about 4.5 square inches. These significant reductions in circuitry are due to the novel compensation circuit 16.

While particular embodiments of the invention have been shown and described, numerous variations and alternate embodiments will occur to those skilled in the art. Accordingly, it is intended that the invention be limited only in terms of the appended claims.

## Claims

1. A compensation circuit (16) for coupling a sensor (18) generating an analog signal in response to a sensed condition comprising:
a memory storing setting value (21);
an analog-to-digital circuit (50, 36) coupled to the memory (21) for converting the analog signal to a digital signal;
a compensation portion (30) coupled to said analog-to-digital circuit (50, 36) for retrieving a setting value from said memory in response to said digital signal;
a track and hold circuit (48) coupled to said analog-to-digital circuit (50, 36); and
an output section (28) generating voltage and current outputs in response to said setting value.

2. The compensation circuit of claim 1, characterized by a digital portion (24) comprising an input buffer (34).

3. The compensation circuit of claim 2, characterized by test circuit (23) coupled to said input buffer (34).

4. The compensation circuit of any of claims 1-3, characterized in that said analog-to-digital circuit (50, 36) and said output section (28) are implemented in an application specific integrated circuit (ASIC).

5. The compensation circuit of any of claims 1-4, characterized in that said sensor (18) comprises a temperature detector.

6. The compensation circuit of any of claims 1-5, characterized in that said analog-to-digital circuit (50, 36) comprises successive approximation registers (36), a comparator (50), and a digital-to-analog circuit (46) having an output coupled to said comparator (50).

7. The compensation circuit of any of claims 1-6, characterized by an automatic level control circuit (38) coupled to said output section (28) and said memory for maintaining a desired output signal level.

8. The compensation circuit of any of claims 1-7, characterized by an attenuator (40) multiplexed to said digital-to-analog circuit (46) for providing a predetermined attenuation level.

9. A control circuit for controlling the operation of an electrical device comprising:
a sensor (18);
a memory (21);
a compensation circuit (16) coupled to said sensor (18), said memory (21) and said electrical device (20), said compensation circuit (16) comprising,
an analog-to-digital circuit (50, 36) coupled to the sensor (18) for converting the analog signal to a digital signal;
a digital-to-analog circuit (46) coupled to the memory (21) for converting the digital value from memory to an analog signal;
a compensation portion (30) coupled to said digital-to-analog circuit (46) for retrieving a setting value from said memory in response to said digital signal;
a track and hold circuit (48) coupled to said digital-to-analog circuit (46); and
an output section (28) coupled to said track and hold circuit (48) generating voltage and current outputs in response to said setting value.

10. The control circuit of claim 9 to control an electrical device (20) such as one from the group consisting of a channel control unit, a driver limiter amplifier, a linearizer unit and a RF circuit.
